# EUROPÄISCHE PATENTSCHRIFT

(11) **EP 0 793 736 B1**
(45) Veröffentlichungstag und Bekanntmachung des Hinweises auf die Patenterteilung: **22.09.1999**
(21) Anmeldenummer: 95936968.7
(22) Anmeldetag: 21.11.1995
(51) Int. Cl.: C23C 16/44, C23C 16/24

(54) **VERFAHREN ZUR HERSTELLUNG MIKROMECHANISCHER BAUELEMENTE MIT FREISTEHENDEN MIKROSTRUKTUREN ODER MEMBRANEN**
PROCESS FOR PREPARING MICROMECHANICAL COMPONENTS HAVING FREE-STANDING MICROSTRUCTURES OR MEMBRANES
PROCEDE DE PRODUCTION DE COMPOSANTS MICROMECANIQUES A MICROSTRUCTURES OU MEMBRANES SEPAREES

(30) Priorität: 22.11.1994 DE 4441541; 17.12.1994 DE 4445177
(43) Veröffentlichungstag der Anmeldung: 10.09.1997
(73) Patentinhaber: FRAUNHOFER-GESELLSCHAFT ZUR FÖRDERUNG DER ANGEWANDTEN FORSCHUNG E.V., 80636 München (DE)
(72) Erfinder: KIRSTEN, Mario, D-14480 Potsdam (DE); LANGE, Peter, D-10965 Berlin (DE); WENK, Beatrice, D-13507 Berlin (DE); RIETHMÜLLER, Werner, D-10551 Berlin (DE)
(74) Vertreter: Gagel, Roland, Dr.
(86) Internationale Anmeldenummer: DE9501650
(87) Internationale Veröffentlichungsnummer: WO9616203

(56) Entgegenhaltungen:
- US-A- 4 897 360
- ELEKTRONIK, Bd. 43, Nr. 19, 20.September 1994 Seite 8 XP 000473199 'ANNOUNCEMENT'
- D.Widmann et al," Technologie hochintergrieter Schaltungen", Springer Verlag 1988 Seite 35

## Beschreibung

Die Erfindung betrifft ein Verfahren zur Herstellung mikromechanischer Bauelemente mit freistehenden Mikrostrukturen oder Membranen, die unter einer vorgebbaren mechanischen Spannung stehen.

Neben der Volumenmikromechanik (bulk micromachining), bei der dreidimensionale Strukturen mittels anisotroper, selektiver Ätzlösungen aus einem Silizium-Wafer herausgeätzt werden, hat die sogenannte Oberflächenmikromechanik (surface micromachining) immer mehr an Bedeutung gewonnen. Mit dieser Technik können freistehende, bewegliche Mikrostrukturen auf einer Substratoberfläche hergestellt werden. Basis für diese Strukturen sind Sandwichsysteme aus verschiedenen Schichten, die selektiv zueinander geätzt werden können. Nach Strukturierung der oben liegenden Schicht (z.B. Polysilizium) wird die darunter liegende Opferschicht (z.B. Siliziumdioxid) naßchemisch entfernt, so daß freistehende, beispielsweise brücken- oder zungenförmige, Strukturen entstehen.

Als Material für diese mechanischen Strukturen wird hauptsächlich polykristallines Silizium (Polysilizium) eingesetzt. Die hierfür erforderlichen Schichtdicken der Polysiliziumschichten liegen im Bereich von einigen µm bis hin zu einigen 10 µm.

Polysiliziumschichten finden auch in elektronischen Bauelementen Verwendung. In diesem Fall liegen die erforderlichen Schichtdicken maximal im Bereich von einigen 100 nm. Die Schichten werden in Niederdruck Chemical Vapor Deposition (LPCVD) Reaktoren abgeschieden. Die LPCVD-Reaktoren weisen jedoch relativ niedrige Schichtabscheideraten von ca. 20 nm/min auf. Die innerhalb akzeptabler Prozeßzeiten zu erreichende Schichtdicke ist daher in diesen Systemen auf etwa 2 µm beschränkt. Für Anwendungsfälle, in denen Schichtdicken bis zu einigen 10 µm erforderlich sind, ist dieses Abscheideverfahren demnach nicht geeignet.

Ein weiterer Nachteil der in diesen Systemen hergestellten Polysiliziumschichten ist die entstehende mechanische Spannung im Polysilizium. Die in der Mikroelektronik standardmäßig verwendeten Prozeßtemperaturen liegen zwischen 630°C und 650°C. Bei diesen Temperaturen steht die abgeschiedene Polysiliziumschicht immer unter Druckspannung (vgl. z.B. H. Guckel et al., Tech. Digest, 4th Int. Conf. Solid-State Sensors and Actuators (Transducers 87), Tokyo, Japan, 2-5 June 1987, pp. 277). Für viele Anwendungsbereiche in der Mikromechanik sind jedoch Zugspannungen im Material erwünscht, da beispielsweise Membranen oder Brückenstrukturen im Fall von Druckspannungen Wölbungen ausbilden.

Ein bekanntes Verfahren zur Herstellung von Polysiliziumschichten mit Zugspannungen, wie dies in H. Guckel et al., 1988, Solid State Sensor & Actuator workshop, Hilton Head Island, SC, 6-9 June 1988m, pp. 96, dargestellt ist, besteht aus einer Abscheidung des Siliziums bei Temperaturen kleiner als 580°C. Bei diesen Temperaturen ist die abgeschiedene Schicht nicht polykristallin, sondem mehr oder weniger amorph. Eine nachfolgende Temperaturbehandlung bei 900°C führt zu einer Kristallisation. Die dabei erfolgende Umordnung der Siliziumatome ist mit einer Volumenkontraktion verbunden, die wiederum zu Zugspannungen im Material führt.

Findet jedoch nachfolgend eine Temperung bei Temperaturen oberhalb von 1000°C statt, so wandeln sich die Zugspannungen wieder in Druckspannungen um.

Ein weiteres Verfahren zur Steuerung der Schichtspannung im LPCVD Polysilizium ist in P. Krulevitch et al., Tech. Digest, 6th Int. Conf. Solid-State Sensors and Actuators (Transducers 91), San Francisco, 24-27 June 1991, pp. 949, beschrieben. Durch geeignete Wahl der Abscheidetemperatur wird in der Schicht eine Zugspannung (T ca. 605°C) oder eine Druckspannung (T>620°C) erzeugt.

Diverse Untersuchungen haben jedoch gezeigt, daß die mit den genannten Verfahren erzeugten Spannungswerte in der Polysiliziumschicht nur schlecht reproduzierbar sind. Zudem ist die innerhalb vertretbarer Prozeßzeiten erreichbare Schichtdicke auf ca. 2 µm begrenzt, so daß diese Verfahren für freistehende Strukturen, die Schichtdicken bis zu einigen 10 µm erfordern, nicht geeignet sind.

Aus T.I.Kamins et al., Thin Solid Films, 16, 147 (1973), ist ein Verfahren zur Herstellung dicker Polysiliziumschichten (1 - 15 µm) bekannt, bei dem das Polysilizium mittels Gasphasenabscheidung (CVD) bei (im Vergleich zu LPCVD) erhöhtem Druck abgeschieden wird. Mit diesem Verfahren werden Abscheideraten von 60 - 500 nm/min erzielt, so daß Polysiliziumschichten mit einer Dicke von 15 µm hergestellt werden können.

Es wird jedoch kein Hinweis darauf gegeben, in welcher Weise die Schichtspannungen der Polysiliziumschichten bei der Abscheidung beeinflußbar sind. Aufgabe der vorliegenden Erfindung ist es daher, ein Verfahren zur Herstellung mikromechanischer Bauelemente mit freistehenden Mikrostrukturen oder Membranen anzugeben, die unter einer vorgebbaren mechanischen Spannung stehen.

Die Aufgabe wird erfindungsgemäß mit den Merkmalen des Verfahrens nach Anspruch 1 gelöst. Besondere Ausgestaltungen und Weiterbildungen des Verfahrens sind Gegenstand der Unteransprüche.

Beim erfindungsgemäßen Verfahren wird das Polysilizium als Material für die freistehende Mikrostruktur oder Membran bei einem im Vergleich zum LPCVD-Verfahren erhöhten Prozeßdruck d.h.bei einem Proceßdruck von mehreren 100 Pa (z.B. 2,7·10³ Pa oder Atmosphärendruck) abgeschieden. Durch geeignete Wahl des Prozeßdruckes kann die Art der Schichtspannung (d.h. Zug- oder Druckspannung) der Polysiliziumschicht, und damit der freistehenden Mikrostruktur oder Membran, eingestellt werden. Der Betrag der Schichtspannung wird durch die Wahl der Prozeßtemperatur bestimmt. So läßt sich beispielsweise bei einer Prozeßtemperatur von 1000°C mit einem Druck von 10,6·10³ Pa eine Zugspannung mit einem Betrag von ca. 3 MPa erzeugen, während bei gleicher Prozeßtemperatur und Atmosphärendruck als Prozeßdruck eine Druckspannung in der Polysiliziumschicht erzeugt wird. Bei dem gleichen Prozeßdruck (z.B. 10,6·10³ Pa) können durch die Wahl der Prozeßtemperatur unterschiedliche Beträge der Schichtspannung eingestellt werden, so z.B. 3MPa bei 1000°C gegenüber 7,5 MPa bei 940°C, wobei allgemein mit einer höheren Temperatur eine niedrigere Spannung erzeugt wird.

Mit dem erfindungsgemäßen Verfahren werden Abscheideraten von mehreren 100 nm/min erzielt, so daß in vorteilhafter Weise die Herstellung von dikken Polysiliziumschichten (= 10 µm), durch die die freistehenden Strukturen oder Membranen gebildet werden, innerhalb vertretbarer Prozeßzeiten (< 20 min) ermöglicht wird.

Ein besonderer Vorteil des erfindungsgemäßen Verfahrens besteht darin, daß allein durch Variation der Abscheideparameter Druck und Temperatur der Betrag sowie die Art der Schichtspannung von Druckspannung bis Zugspannung reproduzierbar eingestellt werden kann. Damit lassen sich freistehende Mikrostrukturen oder Membranen mit vorgebbaren mechanischen Spannungen reproduzierbar herstellen.

Das Verfahren läßt sich zudem ohne Umrüstung in bereits bekannten Reaktoren durchführen, insbesondere in Batch oder Einzelscheiben Polysilizium oder Monosilizium (Epitaxie) Reaktoren (vgl. Anspruch 4). Die Prozeßtemperaturen lassen sich in diesen Reaktoren problemlos im Bereich von 600 - 1200°C variieren. Hohe Gasflüsse im Bereich von z.B. 200 - 1200 sccm/min sind einstellbar.

Bei der Polysiliziumabscheidung auf einem Siliziumwafer verhindert eine Oxidschicht auf dem Wafer gemäß Anspruch 5 die Bildung von einkristallinem Silizium. Zur Förderung der Nukleation kann auf die Oxidschicht zunächst eine dünne LPCVD-Polysiliziumschicht aufgebracht werden (Anspruch 6). Substrate aus Keramik, Quarz oder anderen Materialien sind ebenfalls einsetzbar.

In Weiterbildung des erfindungsgemäßen Verfahrens wird gemäß Anspruch 8 die Leitfähigkeit der Polysiliziumschicht durch Beimischen definierter Mengen von bor- oder phosphor-haltigen Gasen (z.B. Phosphin (PH₃)) zum Reaktionsgas eingestellt. Durch diese in-situ Dotierung lassen sich Schichtwiderstände (der Schichtwiderstand in Ω/□ ergibt sich durch Integration des Leitwertes über die Tiefe der Polysiliziumschicht) von 10Ω/□ bis zu einigen kΩ/□ erzeugen. Damit wird das Polysiliziummaterial elektrisch leitfähig und somit die Auswertung von bzw. die Ansteuerung mit elektrischen Signalen bei Sensoren und Aktoren möglich.

Zur Erzeugung von hohen Vorspannungen, z.B. zum Versteifen von Membranen, können gemäß Anspruch 9 oberhalb und/oder unterhalb der Polysiliziumschicht weitere Schichten mit hohen inneren Zugspannungen aufgebracht werden.

Das erfindungsgemäße Verfahren wird nachfolgend anhand des Ausführungsbeispiels und der Zeichnungen näher erläutert.

Dabei zeigen:
Figur 1: Spannungswerte (zugspannung) von Polysiliziumschichten, die bei unterschiedlichen Prozeßtemperaturen bei Unterdruck abgeschieden wurden;
Figur 2: Spannungswerte von Polysiliziumschichten in Abhängigkeit von der Prozeß-temperatur bei unterschiedlichen Prozeßdruckwerten;
Figur 3: schematisch einen Prozeßablauf zur Herstellung mikromechanischer Strukturen aus Polysilizium.

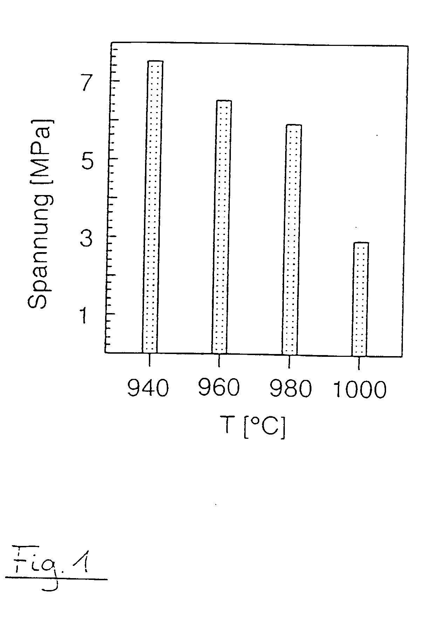

Ein Beispiel für unterschiedliche Zugspannungen von Polysiliziumschichten, die mit dem erfindungsgemäßen Verfahren bei Unterdruck (hier: 10,6·10³ Pa) abgeschieden wurden, ist in Figur 1 dargestellt. Die Abhängigkeit der Spannungswerte von der Prozeßtemperatur T sind deutlich zu erkennen. In einem Temperaturbereich von 940°C bis 1000°C ändern sich die Spannungen von ca. 7,5 MPa bis 3 MPa.

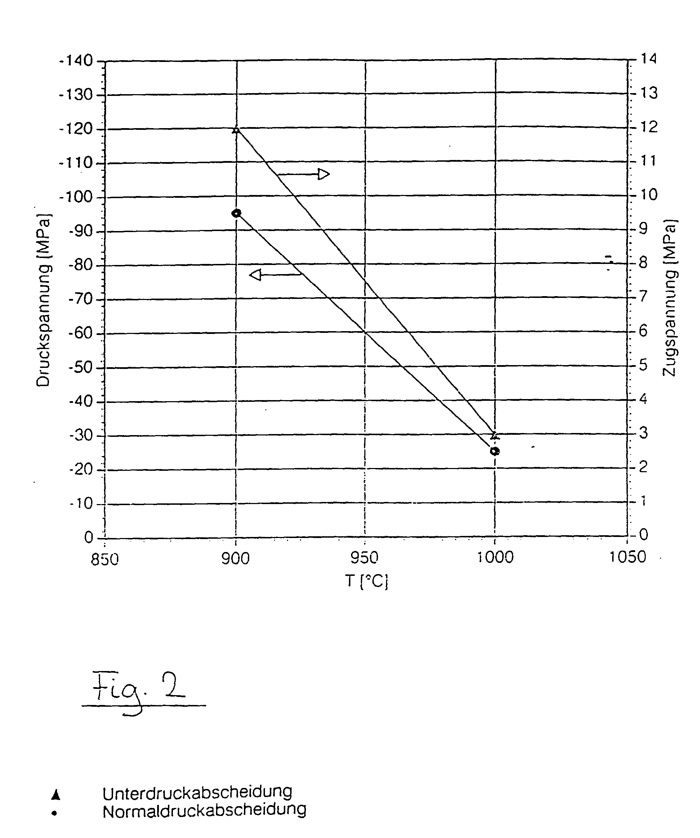

Figur 2 zeigt die Abhängigkeit der inneren Spannungen der erfindungsgemäß abgeschiedenen Polysiliziumschichten von der Prozeßtemperatur (mit durchgezogenen Linien angedeutet) bei zwei unterschiedlichen Einstellungen des Prozeßdruckes. Mit steigender Prozeßtemperatur sinken die Spannungswerte der Polysiliziumschicht sowohl bei Druck- als auch bei Zugspannungen. Bei der Unterdruckabscheidung (10,6·10³ Pa; mit gefüllten Dreiecken gekennzeichnet) treten betragsmäßig kleine Zugspannungen, bei Normaldruckabscheidung (Atmosphärendruck; mit gefüllten Kreisen gekennzeichnet) dagegen Druckspannungen bis zu 0,1 GPa auf.

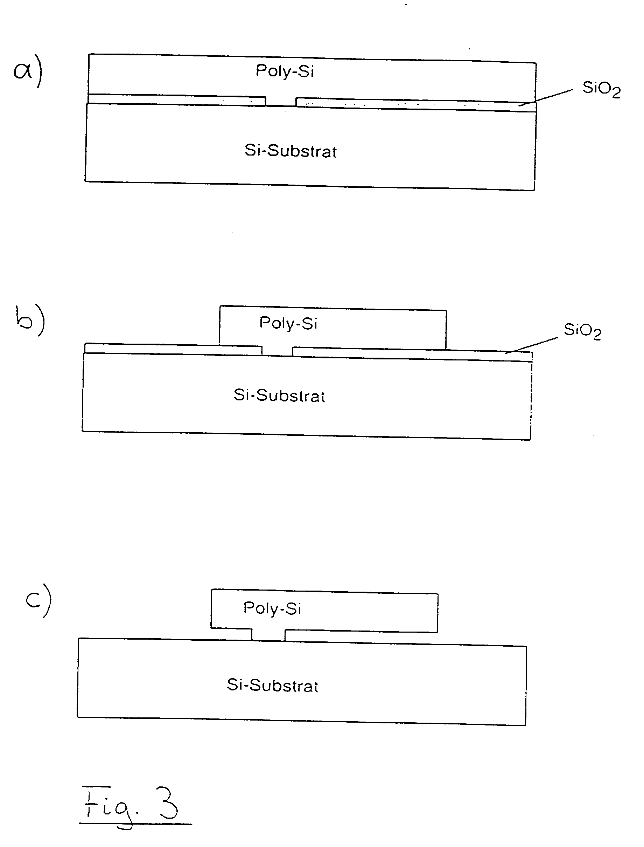

Ein Ausführungsbeispiel für die Herstellung eines mikromechanischen Bauelements mit einer freitragenden Struktur aus Polysilizium wird anhand von Figur 3 erläutert.

Ein typischer Schichtaufbau besteht aus einem Siliziumsubstrat mit einer Opferschicht aus Siliziumdioxid (SiO₂), auf die eine Polysiliziumschicht aufgebracht wird (Figur 3a). Die Polysiliziumschicht mit einer Dicke von 10 µm wird in einem Epitaxie-Batch-Reaktor mit Dichlorsilan (SiH₂Cl₂), Siliziumtetrachlorid (SiCl₄), Trichlorsilan (SiHCl₃) oder Silan (SiH₄) als Reaktionsgas bei einem hohen Gasfluß abgeschieden. Zur Erzeugung einer Zugspannung von weniger als 10 MPa in der Polysiliziumschicht erfolgt die Abscheidung bei Unterdruck (ca. 10,6·10³ Pa) und Prozeßtemperaturen zwischen 960°C und 1040°C. Hierbei stellt sich ebenfalls die notwendige hohe Abscheiderate von ca. 500 nm/min (bei einer Prozeßtemperatur von 1000°C) ein, so daß eine 10 µm dicke Polysiliziumschicht innerhalb von 20 min abgeschieden wird. Diese Polysiliziumschicht wird anschließend photolithographisch mit Trockenätztechnik strukturiert (Figur 3b). Nach einer naßchemhchen Ätzung der Opferschicht entstehen so freitragende Strukturen (hier: 10 µm dicke Polysiliziumstege; Figur 3c), die die Spannungswerte der Polysiliziumschicht aufweisen.

Zur Förderung der Nukleation oder zur gezielten Einstellung bestimmter Schichteigenschaften kann das Opferoxid vor der Polysiliziumabscheidung mit einer dünnen CVD-Polysiliziumschicht (Nukleationsschicht) versehen werden.

## Patentansprüche

1. Verfahren zur Herstellung mikromechanischer Bauelemente mit freistehenden Mikrostrukturen, die unter einer vorgebbaren mechanischen Spannung stehen, bei dem eine Opferschicht auf ein Substrat aufgebracht, auf der Opferschicht eine Polysiliziumschicht in einem Reaktor mittels Gasphasenabscheidung (CVD) abgeschieden und schließlich die Opferschicht zumindest teilweise entfernt wird,
dadurch gekennzeichnet,
daß die Polysiliziumschicht bei einem Prozeßdruck von mehreren 100 Pa abgeschieden wird, wobei die Art der Schichtspannung der Polysiliziumschicht, d.h. Zug- oder Druckspannung, über die Höhe des Prozeßdruckes und der Betrag der Schichtspannung über die Höhe der Prozeßtemperatur im Bereich zwischen 600 und 1200°C eingestellt werden.

2. Verfahren nach Anspruch 1
**dadurch gekennzeichnet,**
daß zur Erzeugung einer Druckspannung in der Schicht der Reaktor bei Atmosphärendruck als Prozeßdurck, und zur Erzeugung einer Zugspannung ein Prozeßdruck im Bereich zwischen 2,7·10³ und 13,3·10³ Pa gewählt wird.

3. Verfahren nach einem der Ansprüche 1 oder 2,
**dadurch gekennzeichnet,**
daß zur Erzeugung einer hohen Schichtspannung eine niedrige Abscheidetemperatur, zur Erzeugung einer geringen Schichtspannung eine hohe Abscheidetemperatur gewählt wird.

4. Verfahren nach einem der Ansprüche 1 bis 3,
**dadurch gekennzeichnet,**
daß als Reaktor ein Epitaxie-Reaktor oder ein Polysilizium-Einzelscheibensystem eingesetzt wird.

5. Verfahren nach einem der Ansprüche 1 bis 4,
**dadurch gekennzeichnet,**
daß als Substrat ein Siliziumwafer mit einer Oxidschicht verwendet wird.

6. Verfahren nach Anspruch 5,
**dadurch gekennzeichnet,**
daß auf die Oxidschicht zunächst eine dünne LPCVD-Polysiliziumschicht abgeschieden wird.

7. Verfahren nach einem der Ansprüche 1 bis 6,
**dadurch gekennzeichnet,**
daß als Reaktionsgas der Gasphasenabscheidung Silan oder Dichlorsilan mit Gasflüssen von 200 - 1200 sccm/min verwendet wird.

8. Verfahren nach einem der Ansprüche 1 bis 7,
**dadurch gekennzeichnet,**
daß der elektrische Widerstand der Polysiliziumschicht durch Beimischen definierter Mengen von bor- oder phosphorhaltigen Gasen zum Reaktionsgas eingestellt wird.

9. Verfahren nach einem der Ansprüche 1 bis 8,
**dadurch gekennzeichnet,**
daß oberhalb und/oder unterhalb der Polysiliziumschicht weitere Schichten mit hohen inneren Zugspannungen aufgebracht werden.

10. Verfahren nach einem der Ansprüche 1 bis 9,
**dadurch gekennzeichnet,**
daß Polysiliziumschichten mit Schichtdicken von mehreren µm hergestellt werden.

## Claims

1. A process for preparing micromechanical components having free-standing microstructures under predeterminable mechanical stress, in which a sacrificial layer is deposited on a substrate, a polysilicon layer is deposited on the sacrificial layer by gaseous phase deposition (CVD) in a reactor and, finally, the sacrificial layer is at least partially removed,
**characterized by the fact**
that the polysilicon layer is deposited at a process pressure of several 100 Pa, whereby the type of layer stress of the polysilicon layer, i.e. tensile or compressive stress, is set by way of the process pressure level; and the value of the layer stress is set by way of the process temperature level in the range between 600 and 1200°C.

2. The process of claim 1,
**characterized by the fact**
that for generating compressive stress in the layer the reactor is operated at atmospheric pressure as operating pressure, and that for generating tensile stress a process pressure is set in the range between 2,7 x10³ and 13,3 x 10³ Pa.

3. The process of claim 1 or 2,
**characterized by the fact**
that for generating high layer stress low deposition temperature is selected and for generating low layer stress high deposition temperature is selected.

4. The process of one of claims 1 to 3,
**characterized by the fact**
that an epitaxy reactor or a polysilicon single wafer system is utilized as a reactor.

5. The process of one of claims 1 to 4,
**characterized by the fact**
that a silicon wafer with an oxide layer is utilized as a substrate.

6. The process of claim 5,
**characterized by the fact**
that a thin LPCVD polysilicon layer is initially deposited on the oxide layer.

7. The process of one of claims 1 to 6,
**characterized by the fact**
that silane or dichlorosilane at gaseous flows of 200 - 1,200 sccm/min are utilized as the reaction gas of the gaseous phase deposition.

8. The process of one of claims 1 to 7,
**characterized by the fact**
that the electrical resistance of the polysilicon layer is set by admixing defined quantities of gases containing boron or phosphorus to the reaction gas.

9. The process of one of claims 1 to 8,
**characterized by the fact**
that further layers with high internal tensile stresses are deposited above and/or below the polysilicon layer.

10. The process of one of claims 1 to 9,
**characterized by the fact**
that polysilicon layers are fabricated having layer thicknesses of several µm.

## Revendications

1. Procédé de fabrication de composants micromécaniques possédant des microstructures séparées soumises à une contrainte mécanique prédéfinie, dans lequel une couche sacrifiée est appliquée sur un substrat, une couche de polysilicium est déposée sur la couche sacrifiée dans un réacteur au moyen d'un dépôt en phase gazeuse (CVD) et la couche sacrifiée est ensuite éliminée au moins en partie, caractérisé en ce que la couche de polysilicium est déposée à une pression de plusieurs centaines de pascals, le type de contrainte dans la couche de polysilicium, c'est-à-dire la traction ou la poussée, étant ajusté par la grandeur de la pression de process et la grandeur de la contrainte dans la couche étant ajustée par la température de process entre 600 et 1200 °C.

2. Procédé selon la revendication 1, caractérisé en ce qu'en vue d'obtenir une contrainte de pression dans la couche, le réacteur est piloté avec une pression de process correspondant à la pression atmosphérique, et pour obvenir une contrainte de traction la pression de process est sélectionnée entre 2,7x10³ et 13,3x10³ Pa.

3. Procédé selon l'une quelconque des revendications 1 ou 2, caractérisé en ce que pour obtenir une contrainte élevée dans la couche, on choisit une température de dépôt basse, et pour obtenir une faible contrainte dans la couche on sélectionne une température de dépôt élevée.

4. Procédé selon l'une quelconque des revendications 1 à 3, caractérisé en ce que le réacteur utilisé est un réacteur d'épitaxie ou un système à plaquette unique pour polysilicium.

5. Procédé selon l'une quelconque des revendications 1 à 4, caractérisé en ce que le substrat utilisé est une galette de silicium avec une couche d'oxyde.

6. Procédé selon la revendication 5, caractérisé en ce qu'une fine couche de polysilicium est d'abord déposée par LPCVD sur la couche d'oxyde.

7. Procédé selon l'une quelconque des revendications 1 à 6, caractérisé en ce que le gaz de réaction utilisé pour le dépôt en phase gazeuse est du silane ou du dichlorosilane à un débit de 200 à 1200 sccm/min.

8. Procédé selon l'une quelconque des revendications 1 à 7, caractérisé en ce que la résistance électrique de la couche de polysilicium est ajustée par l'ajout de quantités définies de gaz contenant du bore ou du phosphore dans le gaz de réaction.

9. Procédé selon l'une quelconque des revendications 1 à 8, caractérisé en ce que d'autres couches ayant des contraintes internes élevées sont appliquées par-dessus et/ou par-dessous la couche de polysilicium.

10. Procédé selon l'une quelconque des revendications 1 à 9, caractérisé en ce que les couches de polysilicium produites ont une épaisseur de plusieurs microns.
